# EUROPEAN PATENT APPLICATION

(11) **EP 2 428 356 A1**
(43) Date of publication of application: **14.03.2012**
(21) Application number: 09844219.7
(22) Date of filing: 05.05.2009
(51) Int. Cl.: B32B 7/02, B41M 3/06

(54) **PATTERNED GAME CARD AND GAME METHOD**

(71) Applicant: Ideal Worldwide Limited, Kowloon, Hong Kong (CN)
(72) Inventor: KUAN, Yi-Hui, Zhonghe City Taipei County Taiwan (CN)
(74) Representative: 2K Patentanwälte Blasberg Kewitz & Reichel
(86) International application number: PCT/CN2009/000487
(87) International publication number: WO 2010/127467

(57) **Abstract**

A game card used for revealing hidden information thereof by a transparent color rendering sheet having a predetermined color for passing a light with a specific wavelength range, The game card includes a transparent substrate; and a transparent color layer formed on the transparent substrate and comprising a game pattern formed by overlapping a hidden portion and a cover portion, wherein the hidden portion has at least two different colors for blocking the light with the specific wavelength range and the cover portion does not has the color for blocking the light with the specific wavelength range, whereby when the transparent color rendering sheet is overlapped on the game card, the cover portion reveals a lighter color similar to the predetermined color after rendering with the transparent color rendering sheet, and the hidden portionreveals a darker color after rendering with the transparent color rendering sheet,

## Description

### BACKGROUND OF THE INVENTION

### 1. Field of the Invention

The present invention relates to a game card and a playing method thereof, in particular to a game card and a playing method thereof which utilizing color rendering theory to reveal hidden image in the game card.

### 2. Description of Related Art

In order to get people's attention on specific product or service, advertisement sheets of the product or the service are often made by product manufacturer or service provider to sent to people to read information about the product or the service. Apparently, the attraction of contents printed on the advertisement sheets will greatly affect people's interests on it.

However, conventional advertisement sheets which only printed with some words or pictures can not provide more fun for people. That means they can not get people's more attention on the product or the service, the advertising effect of the advertisement sheets will consequently decrease.

Therefore, it will be useful to design an interactive game mechanism integrated in the advertisement sheets, so that people can interact with the advertisement sheets for getting more fun and the impression of the product or service will definitely increased in people's mind.

### SUMMARY OF THE INVENTION

The object of the present invention is to provide a game card which can be applied on advertisement sheets to make user have more fun and increase the impression of the product or service in people's mind.

Another object of the present invention is to provide a game playing method which can be applied on advertisement sheets to make user have more fun and increase the impression of the product or service in people's mind.

In order to achieve aforementioned purpose, the present invention provides a game card for revealing hidden information thereof by a transparent color rendering sheet having a predetermined color for passing a light with a specific wavelength range. The game card includes a transparent substrate; and a transparent color layer formed on the transparent substrate and comprising a game pattern formed by overlapping a hidden portion and a cover portion, wherein the hidden portion has at least two different colors for blocking the light with the specific wavelength range and the cover portion does not has the color for blocking the light with the specific wavelength range, whereby when the transparent color rendering sheet is overlapped on the game card, the cover portion reveals a lighter color similar to the predetermined color after rendering with the transparent color rendering sheet, and the hidden portion reveals a darker color after rendering with the transparent color rendering sheet.

Further, the present invention provides a game card, for revealing hidden information thereof by a light source emitting a predetermined color light with a specific wavelength range, the game card includes a transparent substrate; and a transparent color layer formed on the transparent substrate and comprising a game pattern formed by overlapping a hidden portion and a cover portion, wherein the hidden portion has at least two different colors for blocking the predetermined color light with the specific wavelength range and the cover portion does not has the color for blocking the predetermined color light with the specific wavelength range, whereby when the predetermined color light is projected on the game card, the cover portion reveals a lighter color similar to the predetermined color, and the hidden portion reveals a darker color after rendering with the predetermined color light.

Further, the present invention provides a game playing method, includes following steps: (a) providing a transparent color rendering sheet having a predetermined color for passing a light with a specific wavelength range; (b) providing a game pattern by a display, the game pattern formed by overlapping a hidden portion and a cover portion, wherein the hidden portion shows at least two different colors for emitting a light without the specific wavelength range and the cover portion shows a color for emitting the light with the specific wavelength range; and (c) overlapping the transparent color rendering sheet in front of the game pattern, the cover portion reveals a lighter color similar to the predetermined color after rendering with the transparent color rendering pattern, and the hidden portion reveals a darker color after rendering with the transparent color rendering sheet.

Further, the present invention provides a game playing method, includes following steps: (a) providing a transparent color rendering pattern and a game pattern by a display, the transparent color rendering pattern having a predetermined color for emitting a light with a specific wavelength range and the degree of transparency thereof is not zero, the game pattern formed by overlapping a hidden portion and a cover portion, wherein the hidden portion shows at least two different colors for emitting a light without the specific wavelength range and the cover portion shows a color for emitting the light with the specific wavelength range; and (b) overlapping the transparent color rendering pattern with the game pattern, the cover portion reveals a lighter color similar to the predetermined color after rendering with the transparent color rendering sheet, and the hidden portion reveals a darker color after rendering with the transparent color rendering sheet.

### BRIEF DESCRIPTION OF THE DRAWINGS

The features of the invention believed to be novel are set forth with particularity in the appended claims. The invention itself however may be best understood by reference to the following detailed description of the invention, which describes certain exemplary embodiments of the invention, taken in conjunction with the accompanying drawings in which:
Fig. 1 is a perspective view of a game card according to a first embodiment of the present invention;
Fig. 2 is a perspective view of a hidden portion of the game card according to the first embodiment of the present invention;
Fig. 3 is a perspective view of a cover portion of the game card according to the first embodiment of the present invention;
Fig. 4 is a perspective view of a game card according to the first embodiment of the present invention;
Fig. 5 is a perspective view of a game card according to a second embodiment of the present invention;
Fig. 6 is a perspective view of a game playing method according to a third embodiment of the present invention;
Fig. 7 is a perspective view of a game playing method according to a third embodiment of the present invention; and
Fig. 8 is a perspective view of a game playing method according to a forth embodiment of the present invention.

### DETAILED DESCRIPTION OF THE INVENTION

A detailed description of the present invention will be made with reference to the accompanying drawings,

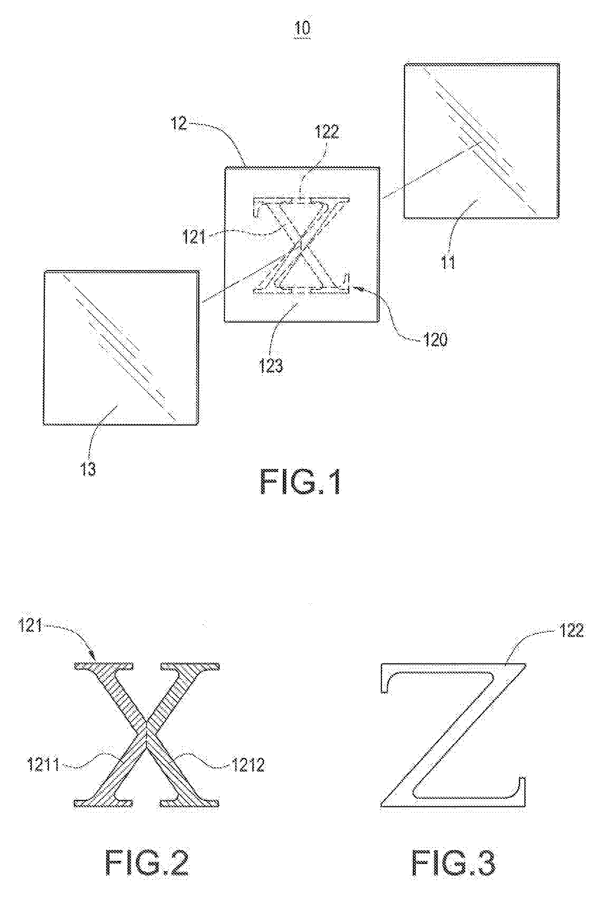

FIG. 1 shows a game card 10 according to a first embodiment of the present invention. The game card 10 can reveal hidden information thereof by a transparent color rendering sheet (not shown) which having a predetermined color for passing a light with a specific wavelength range. The specific wavelength range can have a continuous range or a plurality of discontinuous ranges.

As Fig. 1, Fig.2 and Fig. 3 show, the game card 10 includes a transparent substrate 11, a transparent color layer 12 formed on the transparent substrate 11 and a transparent protective layer 13. The transparent substrate 11 can be made of plastic material like polyethylene terephthalate (PET), but not limited thereto. The transparent color layer 12 has a game pattern 120 formed by overlapping a hidden portion 121 and a cover portion 122.

The hidden portion 121 can be a predetermined word or pattern which has at least two different colors four blocking the light with the specific wavelength range. In this embodiment, the hidden portion 121 is a character X, but mot limited thereto in practical use. The cover portion 122 is used to interference human eye to clearly recognize the hidden portion 121. The cover portion 122 can be another predetermined word or pattern which does not has the color for blocking the light with the specific wavelength range. In other words, the cover portion 122 has at least one color for passing the light with the specific wavelength range. In this embodiment, the cover portion 122 is a character Z, but mot limited thereto in practical use.

In practically manufacturing, the hidden portion 121 and the cover portion 122 are overlapped synthesis as the game pattern 120 in an electronic file by computer software, Then the electronic file of the game pattern 120 can be put into a printing machine with CMYK four colors printing to print the transparent color layer 12 onto the transparent substrate 11. Therefore, the transparent color layer 12 has a cyan color sublayer, a magenta color sublayer, a yellow color sublayer and a black color sublayer. Besides, a printing machine with RGB three colors printing is also can be applied.

In addition, a background portion 123 is arranged adjacent to the game pattern 120. The background portion 123 has at least one color for passing the light with the specific wavelength range which is different from the color of the cover portion 122. The background portion 123 can be put on certain pattern like trade mark, name of product or some advertising words.

The transparent protective layer 13 is formed on the transparent color layer 12, Further, the transparent protective layer 13 can have a foggy surface with a cover pattern thereon to interference the human eye to recognize the hidden portion 121. In the other way, the transparent protective layer 13 can have a smooth surface to increase the color rendering effect of the transparent color layer 12.

When a user observe the game card 10 alone, because the hidden portion 121 is overlapped with the cover portion 122 which will interference human eye to clearly recognize the hidden portion 121, so that it is not easy for user to recognize the hidden portion 121.

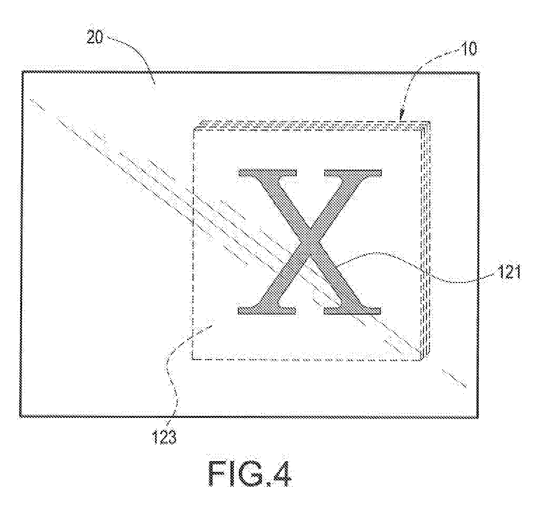

As Fig.1 and Fig.4, the transparent color rendering sheet 20 is overlapped in front of the game card 10, and environmental light is passed through the game card 10 and the transparent color rendering sheet 20. Since the cover portion 122 and the background portion 123 both have colors for passing the light with the specific wavelength range, and the transparent color rendering sheet 20 also has color for passing the light with the specific wavelength range, user can observes that the cover portion 122 and the background portion 123 reveal lighter colors similar to the predetermined color after rendering with the transparent color rendering sheet, thus the pattern of the cover portion 122 and the background portion 123 are not easy to be recognized by human eye.

Since the hidden portion 121 has colors for blocking the light with the specific wavelength range, and the transparent color rendering sheet 20 has color for passing the light with the specific wavelength range, user can observes that the hidden portion 121 reveals a darker color after rendering with the transparent color rendering sheet 20, thus the pattern of the hidden portion 121 is easy to be recognized by human eye.

Several examples of the above mentioned embodiment are described below:

### <Example 1>

The color of the transparent color rendering sheet 20 is set to be blue, the colors of the hidden portion 121 are set to be yellow and green, the cover portion 122 is set to be blue. The yellow color of the hidden portion 121 can be provided by a yellow color sublayer. The blue color of the cover portion 122 can be provided by color mixing of a cyan color sublayer and a magenta color sublayer. When the transparent color rendering sheet 20 is overlapped in front of the game card 10, the color of the cover portion 122 is blue as the transparent color rendering sheet 20, and the color of the hidden portion 121 is substantial black, so that user can easily recognize the pattern of the hidden portion 121.

### <Example 2>

The color of the transparent color rendering sheet 20 is set to be purple, the colors of the hidden portion 121 are set to be yellow, and the cover portion 122 is set to be purple. When the transparent color rendering sheet 20 is overlapped in front of the game card 10, the color of the cover portion 122 is purple as the transparent color rendering sheet 20, and the color of the hidden portion 121 is substantial black, so that user can easily recognize the pattern of the hidden portion 121.

### <Example 3>

The color of the transparent color rendering sheet 20 is set to be orange, the colors of the hidden portion 121 are set to be cyan, and the cover portion 122 is set to be orange. When the transparent color rendering sheet 20 is overlapped in front of the game card 10, the color of the cover portion 122 is orange as the transparent color rendering sheet 20, and the color of the hidden portion 121 is substantial black, so that user can easily recognize the pattern of the hidden portion 121.

### <Example 4>

The color of the transparent color rendering sheet 20 is set to be green, the colors of the hidden portion 121 are set to be red, and the cover portion 122 is set to be green. When the transparent color rendering sheet 20 is overlapped in front of the game card 10, the color of the cover portion 122 is green as the transparent color rendering sheet 20, and the color of the hidden portion 121 is substantial black, so that user can easily recognize the pattern of the hidden portion 121,

### <Example 5>

The color of the transparent color rendering sheet 20 is set to be cyan, the colors of the hidden portion 121 are set to be orange, and the cover portion 122 is set to be cyan. When the transparent color rendering sheet 20 is overlapped in front of the game card 10, the color of the cover portion 122 is cyan as the transparent color rendering sheet 20, and the color of the hidden portion 121 is substantial black, so that user can easily recognize the pattern of the hidden portion 121.

### <Example 6>

The color of the transparent color rendering sheet 20 is set to be yellow, the colors of the hidden portion 121 are set to be purple, and the cover portion 122 is set to be yellow. When the transparent color rendering sheet 20 is overlapped in front of the game card 10, the color of the cover portion 122 is yellow as the transparent color rendering sheet 20, and the color of the hidden portion 121 is substantial black, so that user can easily recognize the pattern of the hidden portion 121,

### <Example 7>

The color of the transparent color rendering sheet 20 is set to be magenta, the colors of the hidden portion 121 are set to be green, and the cover portion 122 is set to be magenta. When the transparent color rendering sheet 20 is overlapped in front of the game card 10, the color of the cover portion 122 is magenta as the transparent color rendering sheet 20, and the color of the hidden portion 121 is substantial black, so that user can easily recognize the pattern of the hidden portion 121.

Besides, the transparent color rendering sheet 20 can also be overlapped in back of the game card 10 to achieve the same effect as the above mentioned embodiment.

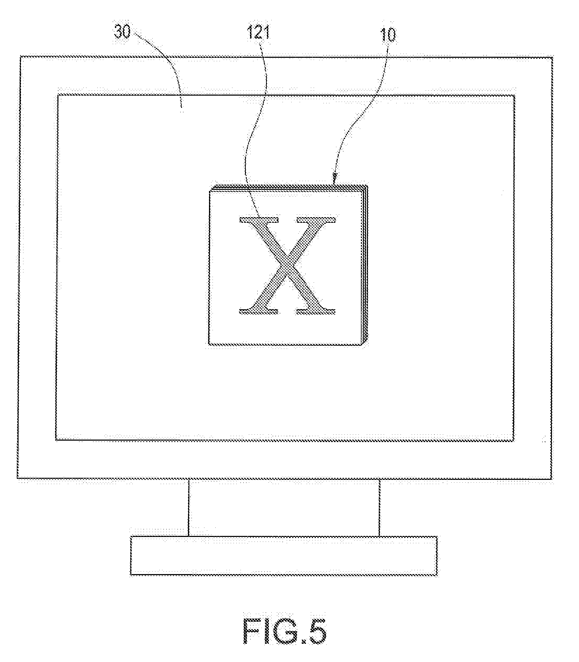

Fig. 5 shows a game card 10 according to a second embodiment of the present invention, which is the same as the game card according to the first embodiment. The difference is that the game card 10 of second embodiment can reveal hidden information thereof by a light source 30 which emits a predetermined color light with a specific wavelength range. In this embodiment, the light source 30 can be a display showing a monochrome pattern 31 emitting a predetermined color light with a specific wavelength range. The display is a computer monitor, a movie screen, a television screen or a handset screen. The specific wavelength range has a continuous range or a plurality of discontinuous ranges.

When a user observe the game card 10 alone, because the hidden portion 121 is overlapped with the cover portion 122 which will interference human eye to clearly recognize the hidden portion 121, so that it is not easy for user to recognize the hidden portion 121.

As Fig, 5 shows, the game card 10 is overlapped in front of the monochrome pattern 31 of the light source 30, and color light of the monochrome pattern 31 is passed through the game card 10. Since the cover portion 122 and the background portion 123 both have colors for passing the light with the specific wavelength range, user can observes that the cover portion 122 and the background portion 123 reveal lighter colors similar to the predetermined color of the monochrome pattern 31, thus the pattern of the cover portion 122 and the background portion 123 are not easy to be recognized by human eye.

Since the hidden portion 121 has colors for blocking the light with the specific wavelength range, user can observes that the hidden portion 121 reveals a darker color after rendering with the predetermined color of the monochrome pattern 31, thus the pattern of the hidden portion 121 is easy to be recognized by human eye.

The game cards of above mentioned two embodiments can be applied on the advertisement sheets, user can not only read words or pictures on the advertisement sheets, but also can play with the game card to get more fun. And the impression of the product or service will definitely increased in user's mind.

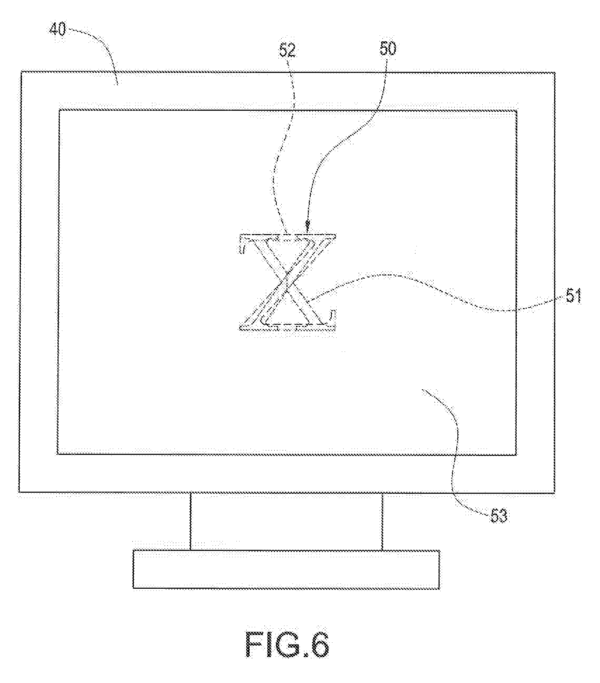

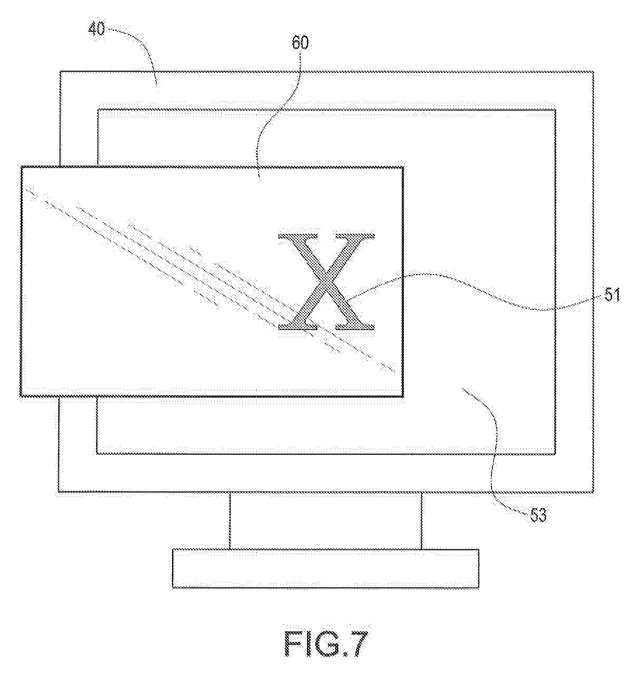

Fig. 6 and Fig.7 show a game playing method according to a third embodiment of the present invention. The game pattern of this embodiment is provided by a display controlled by computer. The game playing method includes following steps. The display is a computer monitor, a movie screen, a television screen or a handset screen.

First, a transparent color rendering sheet 60 is provided. The transparent color rendering sheet 60 has a predetermined color for passing a light with a specific wavelength range. The specific wavelength range has a continuous range or a plurality of discontinuous ranges.

Then, a game pattern 50 is provided by a display 40. The game pattern 50 formed by overlapping a hidden portion 51 and a cover portion 52. The hidden portion 51 shows at least two different colors for emitting a light without the specific wavelength range. The cover portion 52 shows a color for emitting the light with the specific wavelength range. Besides, an overlapping portion of the hidden portion 51 and the cover portion 52 can emit both the light without the specific wavelength range and the light with the specific wavelength range. A background portion 53 is arranged adjacent to the game pattern 50. The background portion 53 has at least one color for passing the light with the specific wavelength range,

When a user observe the game pattern 50 alone, because the hidden portion 51 is overlapped with the cover portion 52 which will interference human eye to clearly recognize the hidden portion 51, so that it is not easy for user to recognize the hidden portion 51.

When the transparent color rendering sheet 60 is overlapped in front of the game pattern 50, the cover portion 52 and the background portion 53 reveal lighter colors similar to the predetermined color after rendering with the transparent color rendering sheet 60, thus user can not recognize the pattern on the cover portion 52 and the background portion 53.

Since the hidden portion 51 has colors for emitting a light without the specific wavelength range, and the transparent color rendering sheet 60 has color for passing the light with the specific wavelength range, user can observe that the hidden portion 51 reveals a darker color after rendering with the transparent color rendering sheet 60, thus the pattern of the hidden portion 51 is easy to be recognized by human eye.

The transparent color rendering sheet 60 can be applied on an advertisement sheet. User can not only read the information on the advertisement sheet, but also can use this transparent color rendering sheet 60 to play with a game pattern 50 provided by display 40 to have more fun.

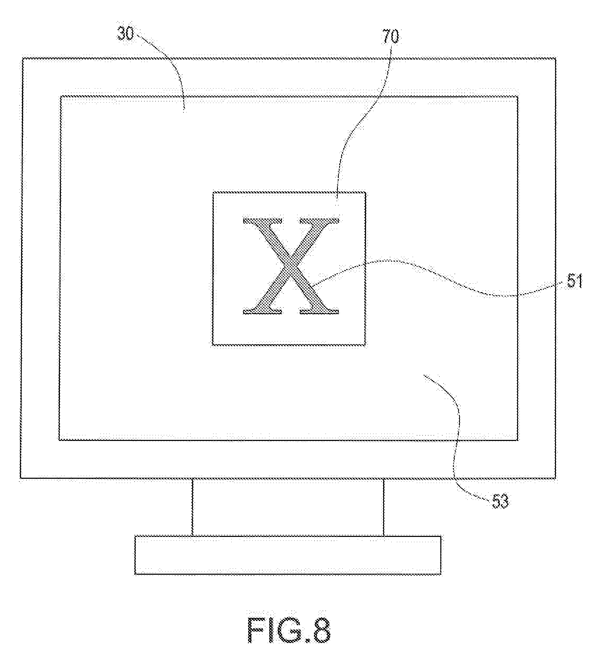

Fig. 6 and Fig.8 show a game playing method according to a forth embodiment of the present invention, which is similar to the third embodiment. The game playing method includes following steps.

First, a transparent color rendering pattern 70 and a game pattern 50 are provided by a display 40, The display can be a computer monitor, a movie screen, a television screen or a handset screen,

The transparent color rendering pattern 70 has a predetermined color for emitting a light with a specific wavelength range and the degree of transparency thereof is not zero. The specific wavelength range has a continuous range or a plurality of discontinuous ranges. In practical use, the transparent color rendering pattern 70 can be made by function of adjusting transparency in commercial software like Adobe Photoshop or Illustrator.

The game pattern 50 is formed by overlapping a hidden portion 51 and a cover portion 52. The hidden portion 51 shows at least two different colors for emitting a light without the specific wavelength range. The cover portion 52 shows a color for emitting the light with the specific wavelength range. Besides, a background portion 53 is arranged adjacent to the game pattern 50. The background portion 53 has at least one color for emitting the light with the specific wavelength range. An overlapping portion of the hidden portion 51 and the cover portion 52 emits both the light without the specific wavelength range and the light with the specific wavelength range.

When a user observe the game pattern 50 alone, because the hidden portion 51 is overlapped with the cover portion 52 which will interference human eye to clearly recognize the hidden portion 51, so that it is not easy for user to recognize the hidden portion 51.

When the transparent color rendering pattern 70 is overlapped with the game pattern 50, the cover portion 52 reveals lighter colors similar to the predetermined color after rendering with the transparent color rendering pattern 70, thus user can not recognize the pattern on the cover portion 52 and the background portion 53.

Since the hidden portion 51 has colors for emitting a light without the specific wavelength range, and the transparent color rendering pattern 70 has color for emitting the light with the specific wavelength range, user can observe that the hidden portion 51 reveals a darker color after rendering with the transparent color rendering pattern 70, thus the pattern of the hidden portion 51 is easy to be recognized by human eye.

The transparent color rendering pattern 70 can be applied on internet advertisement. User can not only read the information on the advertisement, but also can use this transparent color rendering pattern 70 to play with the game pattern 50 provided by display 40 to have more fun.

Although the present invention has been described with reference to the foregoing preferred embodiment, it will be understood that the invention is not limited to the details thereof. Various equivalent variations and modifications can still occur to those skilled in this art in view of the teachings of the present invention. Thus, all such variations and equivalent modifications are also embraced within the scope of the invention as defined in the appended claims.

## Claims

1. A game card, for revealing hidden information thereof by a transparent color rendering sheet having a predetermined color for passing a light with a specific wavelength range, the game card comprising:
a transparent substrate; and
a transparent color layer formed on the transparent substrate and comprising a game pattern formed by overlapping a hidden portion and a cover portion, wherein the hidden portion has at least two different colors for blocking the light with the specific wavelength range and the cover portion does not has the color for blocking the light with the specific wavelength range,
whereby when the transparent color rendering sheet is overlapped on the game card, the cover portion reveals a lighter color similar to the predetermined color after rendering with the transparent color rendering sheet, and the hidden portion reveals a darker color after rendering with the transparent color rendering sheet.

2. The game card according to claim 1, wherein the cover portion has at least one color for passing the light with the specific wavelength range.

3. The game card according to claim 2, wherein the transparent color layer has a cyan color sublayer, a magenta color sublayer, a yellow color sublayer and a black color sublayer.

4. The game card according to claim 1, wherein the transparent color layer further comprises a background portion adjacent to the game pattern, the background portion has at least one color for passing the light with the specific wavelength range.

5. The game card according to claim 1, further comprising a transparent protective layer formed on the transparent color layer.

6. The game card according to claim 5, wherein the transparent protective layer has a foggy surface with a cover pattern thereon.

7. The game card according to claim 5, wherein the transparent protective layer has a smooth surface.

8. The game card according to claim 5, wherein the specific wavelength range has a continuous range or a plurality of discontinuous ranges.

9. A game card, for revealing hidden information thereof by a light source emitting a predetermined color light with a specific wavelength range, the game card comprising:
a transparent substrate; and
a transparent color layer formed on the transparent substrate and comprising a game pattern formed by overlapping a hidden portion and a cover portion, wherein the hidden portion has at least two different colors for blocking the predetermined color light with the specific wavelength range and the cover portion does not has the color for blocking the predetermined color light with the specific wavelength range,
whereby when the predetermined color light is projected on the game card, the cover portion reveals a lighter color similar to the predetermined color, and the hidden portion reveals a darker color after rendering with the predetermined color light.

10. The game card according to claim 9, wherein the cover portion has at least one color for passing the light with the specific wavelength range.

11. The game card according to claim 9, wherein the transparent color layer has a cyan color sublayer, a magenta color sublayer, a yellow color sublayer and a black color sublayer.

12. The game card according to claim 9, wherein the transparent color layer further comprises a background portion adjacent to the game pattern, the background portion has at least one color for passing the light with the specific wavelength range.

13. The game card according to claim 9, further comprising a transparent protective layer formed on the transparent color layer.

14. The game card according to claim 13, wherein the transparent protective layer has a foggy surface with a cover pattern thereon.

15. The game card according to claim 13, wherein the transparent protective layer has a smooth surface.

16. The game card according to claim 9, wherein the specific wavelength range has a continuous range or a plurality of discontinuous ranges.

17. The game card according to claim 9, wherein the light source is a display showing a monochrome pattern emitting a predetermined color light with a specific wavelength range.

18. The game card according to claim 9, wherein the display is a computer monitor, a movie screen, a television screen or a handset screen.

19. A game playing method, comprising:
(a) providing a transparent color rendering sheet having a predetermined color for passing a light with a specific wavelength range;
(b) providing a game pattern by a display, the game pattern formed by overlapping a hidden portion and a cover portion, wherein the hidden portion shows at least two different colors for emitting a light without the specific wavelength range and the cover portion shows a color for emitting the light with the specific wavelength range; and
(c) overlapping the transparent color rendering sheet in front of the game pattern, the cover portion reveals a lighter color similar to the predetermined color after rendering with the transparent color rendering pattern, and the hidden portion reveals a darker color after rendering with the transparent color rendering sheet.

20. The game playing method according to claim 19, wherein the display is a computer monitor, a movie screen, a television screen or a handset screen.

21. The game playing method according to claim 19, wherein an overlapping portion of the hidden portion and the cover portion emits both the light without the specific wavelength range and the light with the specific wavelength range.

22. The game playing method according to claim 19, wherein the display further provides a background portion adjacent to the game pattern, the background portion has at least one color for passing the light with the specific wavelength range.

23. The game playing method according to claim 19, wherein the specific wavelength range has a continuous range or a plurality of discontinuous ranges.

24. A game playing method, comprising:
(a) providing a transparent color rendering pattern and a game pattern by a display, the transparent color rendering pattern having a predetermined color for emitting a light with a specific wavelength range and the degree of transparency thereof is not zero, the game pattern formed by overlapping a hidden portion and a cover portion, wherein the hidden portion shows at least two different colors for emitting a light without the specific wavelength range and the cover portion shows a color for emitting the light with the specific wavelength range; and
(b) overlapping the transparent color rendering pattern with the game pattern, the cover portion reveals a lighter color similar to the predetermined color after rendering with the transparent color rendering sheet, and the hidden portion reveals a darker color after rendering with the transparent color rendering sheet.

25. The game playing method according to claim 24, wherein the display is a computer monitor, a movie screen, a television screen or a handset screen.

26. The game playing method according to claim 24, wherein an overlapping portion of the hidden portion and the cover portion emits both the light without the specific wavelength range and the light with the specific wavelength range.

27. The game playing method according to claim 24, wherein the display further provides a background portion adjacent to the game pattern, the background portion has at least one color for emitting the light with the specific wavelength range.

28. The game playing method according to claim 24, wherein the specific wavelength range has a continuous range or a plurality of discontinuous ranges.
